# EUROPÄISCHE PATENTANMELDUNG

(11) **EP 0 986 290 A2**
(43) Veröffentlichungstag der Anmeldung: **15.03.2000**
(21) Anmeldenummer: 99117263.6
(22) Anmeldetag: 02.09.1999
(51) Int. Cl.: H05K 5/02

(54) **Verfahren zur Herstellung eines feuchtigkeitsundurchlässigen Druckausgleichselement für ein Gehäuse**

(30) Priorität: 07.09.1998 DE 19840761
(71) Anmelder: DaimlerChrysler AG, 70567 Stuttgart (DE)
(72) Erfinder: Baur, Richard, 85276 Pfaffenhofen (DE); Fendt, Günter, 86529 Schrobenhausen (DE)
(74) Vertreter: Kolb, Georg

(57) **Zusammenfassung**

Verfahren zur Herstellung eines feuchtigkeitsundurchlässigen Druckausgleichselements für ein eine elektronische Baugruppe aufnehmendes feuchtigkeitsdichtes Gehäuse

Nachteil dieser bekannten Druckausgleichselemente ist, daß die dabei verwendete Webstoffabdeckung in zusätzlichen Verarbeitungsschritten befestigt werden muß und dabei Verarbeitungsfehler auftreten können, insbesondere eine nicht lückenlose Befestigung, durch die dann dennoch Feuchtigkeit eindringen kann.

Kerngedanke der Erfindung ist es, daß durch Laserbohren mittlerweile mikrofeine Öffnungen in die Gehäusewand eingebracht werden können, deren Durchmesser annähernd die Maschendichte der bisher verwendeten Webstoffe erreicht und damit das Eindringen von Wassertropfen verhindert, ein Druckausgleich durch diese mikrofeinen Bohrungen jedoch möglich ist.

## Beschreibung

Die Erfindung betrifft ein Verfahren zur Herstellung eines feuchtigkeitsundurchlässigen Druckausgleichselements für ein eine elektronische Baugruppe aufnehmendes feuchtigkeitsdichtes Gehäuse.

Gehäuse, die elektronische Baugruppe aufnehmen, müssen feuchtigkeitsdicht ausgeführt werden, damit an der Baugruppe, insbesondere an den Kontakten, keine Korrosion auftreten kann. Druckausgleichselemente werden dabei eingesetzt, um den Druck im Gehäuseinneren an den Druck im Gehäuseäußeren anzupassen, was einerseits für die korrekte Funktionsweise einiger Baugruppen, insbesondere Sensoren, wichtig ist, aber andererseits auch verhindert, daß aufgrund eines sich im Gehäuseinneren aufbauenden Unterdruckes beispielsweise durch Risse im Gehäuse, insbesondere an den Verbindungsstellen zweier Gehäusehälften, Feuchtigkeit, insbesondere Wasserdampf eindringt und kondensiert.

Ein solches Druckausgleichselement ist beispielsweise der DE 91 07 992 U oder der DE 42 34 919 C2 in Form einer Öffnung in der Gehäusewandung zu entnehmen, die mit einer wasserabweisenden Webstoffabdeckung überspannt ist. Aus der DE 32 48 715 A1 ist ein elektrisches Schaltgerät mit einer Membran zum Schutz der Schaltung gegen Feuchtigkeit versehen. Die nicht vorveröffentlichte DE 197 08 116 der Anmelderin lehrt eine zweilagige Folienanordnung, wobei eine der Folien ebenfalls aus wasserabweisendem Webstoff ist, die auch unter den Bezeichnungen Goretex oder Sympatex bekannt sind.

Nachteil dieser bekannten Druckausgleichselemente ist, daß die dabei verwendete Webstoffabdeckung in zusätzlichen Verarbeitungsschritten befestigt werden muß und dabei Verarbeitungsfehler auftreten können, insbesondere eine nicht lückenlose Befestigung, durch die dann dennoch Feuchtigkeit eindringen kann.

Aus der DE 29 02 169 C2 ist darüber hinaus ein Gehäuse bekannt, bei dem durch eine Belüftungsbohrung ebenfalls ein Druckausgleich ermöglicht wird. Bohrungen sind mit einer Größe von 1 bis 3 mm nur so bemessen, daß Insekten nicht eindringen können. Der Feuchtigkeitsschutz kann nur durch die Anordnung dieser Bohrungen an einer regen- oder spritzwassergeschützten Stelle des Gehäuses gewährleistet werden und ist daher unsicher.

Aufgabe der Erfindung ist es daher, ein Verfahren zur Herstellung eines feuchtigkeitsundurchlässigen Druckausgleichselement für ein Gehäuse anzugeben, welches sicher und kostengünstig ist.

Diese Aufgabe wird durch die kennzeichnenden Merkmale des Patentanspruchs 1 gelöst.

Kerngedanke der Erfindung ist es, daß durch Laserbohren mittlerweile mikrofeine Öffnungen in die Gehäusewand eingebracht werden können, deren Durchmesser annähernd die Maschendichte der bisher verwendeten Webstoffe erreicht und damit das Eindringen von Wassertropfen verhindert, ein Druckausgleich durch diese mikrofeinen Bohrungen jedoch möglich ist. Mikrofein bedeutet dabei eine Bohrung im Mikrometerbereich, also zumindest kleiner 1 mm, vorzugsweise kleiner gleich 20 oder sogar 5 µm.

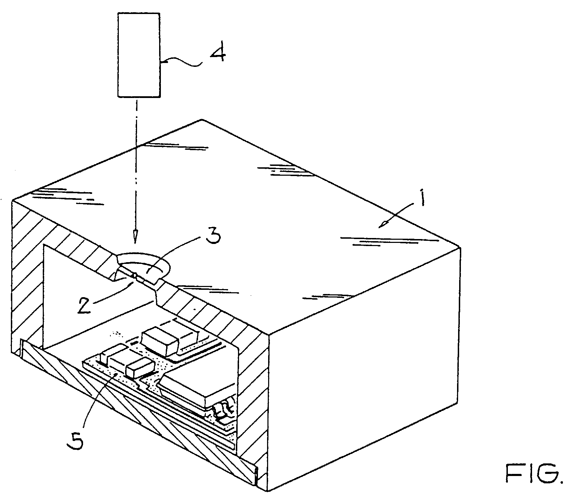

Die Erfindung wird nachfolgend anhand eines Ausführungsbeispiels und einer Figur näher erläutert. Kurze Beschreibung der Figur:
- Figur: Prinzipskizze des Verfahrens zur Herstellung eines feuchtigkeitsundurchlässigen Druckausgleichselements für ein Gehäuse

Die einzige Figur zeigt ein aufgeschnittenes Gehäuse 1 zur Aufnahme einer elektronischen Baugruppe 5, hier dargestellt als bestückte Leiterplatte. Wie in der Figur als Prinzipskizze angedeutet ist, wird mittels eines Lasers 4 durch die Gehäusewand hindurchgehend eine mikrofeine Bohrung eingebracht. Vorzugsweise weist die Gehäusewand im Bereich der Laserbohrung eine Verjüngung 3 auf, um die Erzeugung mikrofeiner Bohrungen zu vereinfachen, deren Durchmesser vorzugsweise kleiner 5 µm ist. Während bereits Bohrungen kleiner 20 µm als ausreichend für einfachere Anwendungen betrachtet werden, sinkt mit dem Durchmesser der Bohrungen auch die Größe der zurückhaltbaren Wassertröpfchen, so daß je nach verfügbarer Lasertechnik die Größe der Bohrungen reduziert werden kann. Um den Druckausgleich zu verbessern, werden eine Vielzahl solcher Laserbohrungen beabstandet voneinander vorgesehen.

## Patentansprüche

1. Verfahren zur Herstellung eines feuchtigkeitsundurchlässigen Druckausgleichselements für ein eine elektronische Baugruppe (5) aufnehmendes feuchtigkeitsdichtes Gehäuse (1), indem in die Gehäusewand mittels eines Lasers (4) wenigstens eine mikrofeine Bohrung (2) eingebracht wird.

2. Verfahren nach Anspruch 1, bei dem der Durchmesser der Laserbohrung(en) kleiner oder gleich 20 µm ist.

3. Verfahren nach Anspruch 2, bei dem der Durchmesser der Laserbohrung(en) kleiner oder gleich 5 µm ist.
